# EUROPEAN PATENT APPLICATION

(11) **EP 0 536 775 A1**
(43) Date of publication of application: **14.04.1993**
(21) Application number: 92117298.7
(22) Date of filing: 09.10.1992
(51) Int. Cl.: G03F 7/30

(54) **Processing method for light-sensitive lithographic printing plates and processing device thereof**

(30) Priority: 11.10.1991 JP 263921/91
(71) Applicant: KONICA CORPORATION, Tokyo 163 (JP)
(72) Inventor: Watanabe, Shinya, Hino-shi, Tokyo (JP); Uehara, Masafumi, Hino-shi, Tokyo (JP); Shimura, Kazuhiro, Hino-shi, Tokyo (JP)
(74) Representative: Henkel, Feiler, Hänzel & Partner

(57) **Abstract**

Disclosed are a processing method for light-sensitive lithographic printing plates comprising a support and provided on one or both sides thereof, a light-sensitive layer, comprising imagewise exposing the light-sensitive layer of the light-sensitive lithographic printing plate and developing the exposed light-sensitive layer, wherein the exposed light-sensitive layer is detected followed by supplying the developing solution only to the detected light-sensitive layer, and a processing device for developing an imagewise exposed light-sensitive layer of a light-sensitive lithographic printing plate by supplying substantially unused developing solution to the exposed light-sensitive layer, the light-sensitive lithographic printing plate comprising a support and provided on one or both sides thereof, a light-sensitive layer, comprising;
a device for detecting the exposed light-sensitive layer, and
a device for supplying the developing solution only to the detected light-sensitive layer.

## Description

### BACKGROUND OF THE INVENTION

The present invention relates to a processing method for light-sensitive lithographic printing plates and processing device thereof, and more particularly, to a processing method and processing device suitable for processing light-sensitive lithographic printing plates having a light-sensitive layer on one surface (to be referred to as "single-sided plates") and light-sensitive lithographic printing plates having light-sensitive layers on both surfaces (to be referred to as "dual-sided plates") with a single processing device.

A processing method and device are known wherein development is performed by supplying essentially unused developing solution to both the upper and lower sides of dual-sided plates while transporting said plates in the horizontal direction (Japanese Unexamined Patent Publication No. 52352/1990, Japanese Unexamined Patent Publication No. 52353/1990, etc.)

However, in this type of processing device, in the case of processing single-sided plates mixed in with dual-sided plates, developing solution ends being supplied to the surface not having a light-sensitive layer thus making such a device uneconomical.

### SUMMARY OF THE INVENTION

Thus, the object of the present invention is to provide a processing method and processing device for light-sensitive lithographic printing plates that allows processing to be performed both economically and stably, even if processing a mixture of dual-sided and single-sided plates, using a system wherein essentially unused developing solution is supplied and then discarded after its use in a single automatic developing machine.

The above-mentioned object of the present invention is accomplished by the processing method of (1) below and the processing device of (2) below.
(1) A processing method for light-sensitive lithographic printing plates comprising a support and provided on one or both sides thereof, a light-sensitive layer, comprising imagewise exposing the light-sensitive layer of the light-sensitive lithographic printing plate and developing the exposed light-sensitive layer, wherein the exposed light-sensitive layer is detected followed by supplying the developing solution only to the detected light-sensitive layer.
(2) A processing device for developing an imagewise exposed light-sensitive layer of a light-sensitive lithographic printing plate by supplying substantially unused developing solution to the exposed light-sensitive layer, the light-sensitive lithographic printing plate comprising a support and provided on one or both sides thereof, a light-sensitive layer, comprising;
   means for detecting the exposed light-sensitive layer, and
   means for supplying the developing solution only to the detected light-sensitive layer.

According to the above-mentioned constitution, since the light-sensitive layer of light-sensitive lithographic printing plates inserted into a processing device is automatically detected followed by the supplying of developing solution to only the surface for which a light-sensitive layer was detected, waste resulting from supplying developing solution to the surface that does not require development is eliminated thereby improving economic feasibility. Moreover, ease of operation is also favorable since selective supplying of developing solution is performed automatically.

### BRIEF DESCRIPTION OF THE DRAWINGS

Fig. 1 is a block drawing indicating an embodiment of the processing device of the present invention.

Fig. 2 is a perspective view of lower surface developing solution supply member 13 in Fig. 1.

Fig. 3 is a cross-sectional view of an example of an amorphous integrated color sensor.

Fig. 4 is a drawing indicating an example of the use of a color sensor.

Fig. 5 is a drawing indicating the positional relationship between the light-sensitive lithographic printing plate, the optical sensor and the light source.

Fig. 6 is a drawing indicating the positional relationship between an optical sensor, in which the light emitting portion and the light receiving portion have been integrated into a single unit, and the light-sensitive lithographic printing plate.

Fig. 7 is a block drawing indicating another embodiment of the processing device of the present invention.

### DESCRIPTION OF THE PREFERRED EMBODIMENTS

The following provides a description of the embodiments of the processing device of the present invention with reference to the drawings. Furthermore, in the following descriptions, the same reference numerals are used for the same constitutional elements, and duplication of explanations have been omitted.

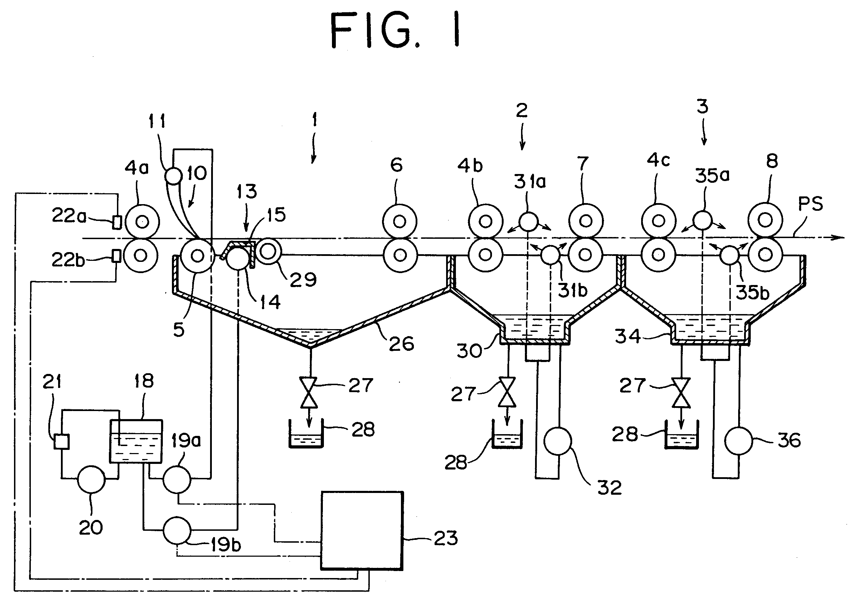

Fig. 1 is a block drawing indicating an embodiment of the processing device of the present invention. In Fig. 1, 1 is a developing portion which develops light-sensitive lithographic printing plates transported horizontally by supplying essentially unused developing solution to the light-sensitive layer of said plates. 2 is a washing portion which performs washing wherein developing solution and eluted substances adhered to the surface of the developed light-sensitive lithographic printing plates are removed. 3 is a rinse/gum portion which performs processing by a rinse solution or insensitive lipidization processing (processing by insensitive lipidization solution (gum solution), and PS is a light-sensitive lithographic printing plate or its transport path.

4a, 4b and 4c are pairs of transport rollers that transport the light-sensitive lithographic printing plates from developing portion 1 to rinse/gum portion 3. 5 is a transport roller, and 6, 7 and 8 are squeeze rollers that squeeze the adhered objects on the surface of the light-sensitive lithographic printing plates. Consequently, light-sensitive lithographic printing plates are transported from left to right horizontally in the drawing.

First, in developing portion 1, 10 is an upper surface developing solution supply member that supplies essentially unused developing solution to the upper surface of the light-sensitive lithographic printing plates being transported. 10 has a slit formed from two plates on its lower end, and is constructed so as to apply developing solution supplied from developing solution supply nozzle 11 onto the upper surface of light-sensitive lithographic printing plates being transported at a uniform liquid thickness over the transport width from said slit. The description of Japanese Unexamined Patent Publication No. 81943/1989 can be referred to for further details regarding said upper surface developing solution supply member 10.

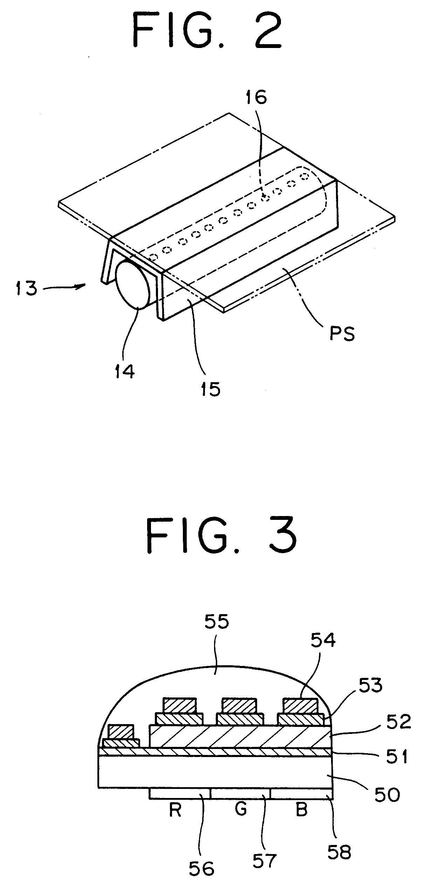

In addition, developing solution is supplied to the lower surface of light-sensitive lithographic printing plates being transported by lower surface developing solution supply member 13. Lower surface developing solution supply member 13 is comprised of developing solution supply pipe 14 and developing solution supply plate 15 that covers said developing solution supply pipe 14, and as indicated in the perspective drawing of Fig. 2, is provided beneath and in close proximity to transport path PS of the light-sensitive lithographic printing plates. Developing solution is supplied by being sprayed onto the lower surface of light-sensitive lithographic printing plates being transported from a plurality of continuous holes 16 provided in the upper portions of developing solution supply pipe 14 and developing solution supply plate 15, respectively.

The developing solution supplied to these developing solution supply members is sent to upper surface developing solution supply member 10 and lower surface developing solution supply member 13 by quantitative pumps 19a and 19b from developing solution contained in developing solution tank 18. In addition, the developing solution in developing solution tank 18 is circulated to heater 21 by pump 20 to control the temperature of said developing solution at the prescribed temperature. On the other hand, optical sensors 22a and 22b are mounted immediately in front of transport path PS and in close proximity to transport path PS to detect the color of the light-sensitive layer of light-sensitive lithographic printing plates inserted into developing portion 1. Examples of sensors used for these optic sensors include color sensors using three-color resolution such as amorphous integrated color sensors, color sensors using two-color resolution such as monolithic color sensors, and single-color color sensors having sensitivity for only a specific color such as amorphous single-color color sensors.

When light-sensitive lithographic printing plates are inserted into the processing device shown in the drawings, and optical sensors 22a and 22b detect the color of the light-sensitive layer, a detection signal is transmitted to control portion 23. Control portion 23 is constructed to activate time-activated quantitative pumps 19a and 19b corresponding to the transport length of the light-sensitive layer of the light-sensitive lithographic printing plates detected by the above-mentioned optical sensors at a prescribed timing based on the detection signals of optical sensors 22a and 22b. 29 is a wire bar that levels out the developing solution supplied to the lower surface of the light-sensitive lithographic printing plates by lower surface developing solution supply member 13. Developing solution that is supplied to the light-sensitive lithographic printing plates by the above-mentioned developing solution supply mechanism and used in development is collected in waste solution tank 26 and contained in waste solution tank 28 by the opening of valve 27.

In washing portion 2, 30 is a washing water tank for containing washing water, 31a and 31b are shower nozzles, and 32 is a pump for sending washing water in washing water tank 30 to shower nozzles 31a and 31b. In rinse/gum portion 3, 34 is a tank for containing rinse solution or insensitive lipidization solution (gum solution), 35a and 35b are shower nozzles for supplying the processing solution in rinse/gum solution tank 34 to the light-sensitive lithographic printing plates, and 36 is a pump for sending the rinse solution or insensitive lipidization solution in rinse/gum solution tank 34 to shower nozzles 35a and 35b.

The following provides an explanation of the processing method of the present invention with reference to the drawings. First, when light-sensitive lithographic printing plates are inserted from the left end of transport path PS in the drawings, the presence or absence of a light-sensitive layer is determined by control section 23 based on signals detected by optical sensors 22a and 22b. According to the result of that determination, pumps 19a and 19b are activated so as to send developing solution to the surface for which a light-sensitive layer was detected at a prescribed timing and for a duration corresponding to the length in the transport direction of the inserted light-sensitive lithographic printing plates.

With respect to the surface for which a light-sensitive layer was detected, developing solution is supplied to the light-sensitive surface for a duration of time corresponding to passage of the light-sensitive layer from upper surface developing solution supply member 10 and/or lower surface developing solution supply member 13 by activation of pumps 19a and/or 19b corresponding to said surface. The light-sensitive layer to which developing solution was supplied is then eluted and developed by developing solution, after which developing solution and eluted substances of the light-sensitive layer adhered to the upper and lower surfaces are squeezed with squeeze roller 6 to complete development. Furthermore, a means of promoting development, such as brushing the surface of the light-sensitive layer with a brush roller, may be optionally added to the above-mentioned development process.

Next, light-sensitive lithographic printing plates are transported to washing portion 2, and washing water contained in washing water tank 30 is supplied to the plate surface of the light-sensitive lithographic printing plates from shower nozzles 31a and 31b by pump 32 to wash the above-mentioned plates. The washed light-sensitive lithographic printing plates are squeezed by squeeze roller 7, transported to rinse/gum portion 3 where rinse processing or insensitive lipidization processing is performed.

Although there are no limitations on the means of distinguishing between surfaces provided with a light-sensitive layer and those that are not in the present invention, examples of preferable means for performing such include a method wherein such distinction is performed by detecting the difference in the reflectance of light between the light-sensitive layer surface and non-light-sensitive layer surface of light-sensitive lithographic printing plates, and a method wherein such distinction is performed by detection of color difference. In the case of the former means, a sensor can be used composed of a sensor, etc. which detects the output of a photodiode equipped with a color filter that selectively allows the passage of light of a specific wavelength band advantageous for distinction of the light-sensitive surface and the non-light-sensitive surface, or which detects the output ratio of two photodiodes equipped with color filters which selectively allow the passage of light of two different specific wavelength bands (to be referred to as a "reflection sensor"). In the case of the latter, a color sensor can be used. Fig. 3 indicates an example of the composition of an amorphous integration type color sensor. In this same drawing, 50 is a glass plate, 51 is a transparent electrically conductive film, 52 is amorphous silicon, 53 is a surface electrode, 54 is a lead frame, 55 is a coating resin, and 55, 56 and 57 are R, G and B color filters, respectively.

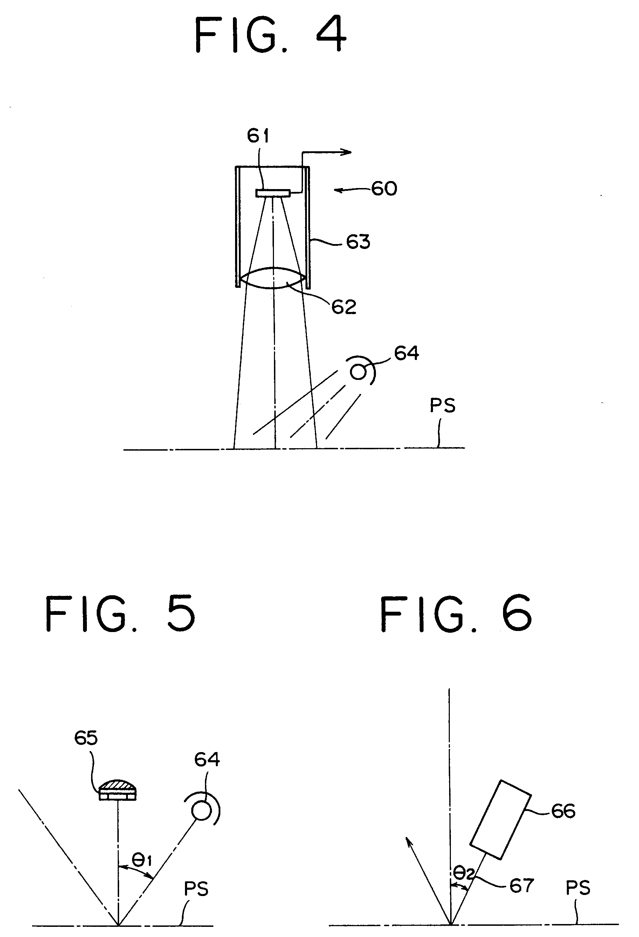

Fig. 4 is a drawing indicating an example of using a color sensor. The example indicated in this same drawing indicates the case of the light projecting portion and the light receiving portion being separate. In this same drawing, 61 is the color sensor, 62 is a lens, 63 is light blocking cylinder, 64 is a light source and PS is a light-sensitive lithographic printing plate or its transport path. Light is illuminated onto the surface of the light-sensitive lithographic printing plate from an inclined direction by light source 64 after which the reflected light in the direction perpendicular to said surface is detected. Various light sources can be used for light source 64, such as a fluorescent lamp, halogen lamp or tungsten lamp.

Fig. 5 is a drawing indicating the positional relationship between light-sensitive lithographic printing plates, the optical sensor and the light source. The example indicated in this same drawing indicates the case in which the light projecting portion and the light receiving portion are separate. In this same drawing, 65 is the optical sensor, 64 is the light source, and ϑ₁ is preferably within the range of 30-60°.

Fig. 6 is a drawing indicating an arrangement example when an optical sensor is used in which the light projecting portion and the light receiving portion are integrated into a single unit. In the case of using this type of sensor, ϑ₂ is preferably within the range of 0-15°.

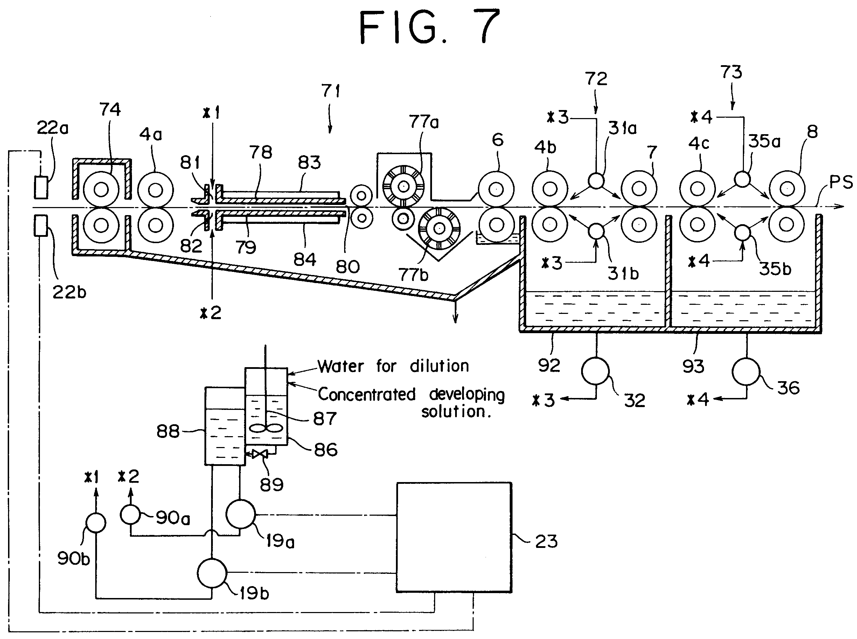

Fig. 7 is a block drawing indicating another embodiment of the present invention. 71 is a developing portion, 72 is a washing portion, 73 is a rinse/gum portion performing rinse processing or insensitive lipidization processing, and PS is a light-sensitive lithographic printing plate or its transport route.

In developing portion 1, 74 is a pair of preheating rollers for preheating the light-sensitive lithographic printing plates sent to developing portion 1 to a prescribed temperature, 4a, 4b and 4c are pairs of transport rollers, 77a and 77b are brush rollers that promote development by brushing the plate surface, and 6, 7 and 8 are squeeze rollers. The pair of preheating rollers 74 consists of a pair of rollers including at least one roller containing an internal heating device. An example of a roller containing an internal heating device that can be used is that having a structure in which a heating element such as a nichrome wire is embedded inside a hollow pipe made of a metal having a high coefficient of thermal conductivity (such as aluminum or iron), with the outside of said metal pipe covered with polyethylene, polystyrene or Teflon, etc. Japanese Unexamined Patent Publication No. 80962/1989 can be referred to for further details regarding such a roller.

Downstream from the pair of transport rollers 4a, upper guide plate 78 and lower guide plate 79 are mounted above and below and in close proximity to transport path PS at a minute distance. Developing solution supply ports 81 and 82 are opened close to the entrances of each of these guide plates. Said guide plates 78 and 79 are constructed so that developing solution supplied from said supply ports 81 and 82 is injected towards transport path PS. Developing solution supply ports 81 and 82 are formed in the shape of slits that extend across the transport width. It is preferable to provide the transport guide described in the specification of Japanese Patent Application No. 7208/1991 of the present applicant, or provide nylon single yarn, etc. on upper guide plate 78 and lower guide plate 79, and particularly on the surface of gap portion 80 of the latter, as a means of allowing developing solution to make adequate contact with the surfaces of the light-sensitive lithographic printing plates being transported without sticking to said plates. Furthermore, the end of gap portion 80 in the direction of transport with is constructed to that it is closed to prevent leakage of developing solution. 83 and 84 are heat insulating devices for regulating upper guide plate 78 and lower guide plate 79 at a prescribed temperature.

Developing solution sent to developing solution supply ports 81 and 82 is composed so as to be sent in the form of a developing solution obtained by diluting concentrated developing solution with distilled water (working solution). In other words, dilution water and concentrated developing solution are sent to developing solution mixing tank 86 where they are mixed and stirred with stirrer 87 and then sent to developing solution supply tank 88. 89 is a solenoid valve, and 19a and 19b are quantitative pumps that send developing solution from developing solution supply tank 88 to respective developing solution supply ports 81 and 82. The control mechanism for injection and mixing of dilution water and concentrated developing solution into developing solution mixing tank 86, and the transfer of mixed developing solution from developing solution mixing tank 86 to developing solution supply tank 88 employs the mechanism described from line 20 of the lower left column to line 17 of the lower right column of page 3 of Japanese Unexamined Patent Publication No. 81959/1989. The lines that connect developing solution supply ports 81 and 82 with quantitative pumps 19a and 19b are equipped with heaters 90a and 90b so that the temperature of the developing solution is regulated within a prescribed range. Furthermore, in Fig. 7, asterisks provided next to numbers (such as *n and *n) indicate those locations that are connected by piping lines.

Optical sensors 22a and 22b are mounted immediately in front of the pair of preheating rollers 74 and in close proximity to and sandwiched above and below transport path PS to detect the color of the light-sensitive layer of light-sensitive lithographic printing plates inserted into developing portion 71. An explanation of detection of the color of the light-sensitive layer by optical sensors 22a and 22b as well as the control of the operation of quantitative pumps 19a and 19b by control portion 23 based on the detection signals from optical sensors 22a and 22b are omitted here as they are the same as in Fig. 1.

In washing portion 72 and rinse/gum portion 73, 31a, 31b, 35a and 35b are shower nozzles, 7 and 8 are squeeze rollers, 92 is a washing water tank, 93 is a rinse/gum tank containing rinse solution or insensitive lipidization solution (gum solution), and 32 and 36 are pumps.

In addition, the device indicated in the drawing has a control mechanism not shown for detecting the carrying in of light-sensitive lithographic printing plates and the length in the transport direction of light-sensitive lithographic printing plates carried in to provide control so that transport rollers 4a, 4b and 4c, brush rollers 77a and 77b, and squeeze rollers 6, 7 and 8, etc. all operate at the prescribed timing. Furthermore, Fig. 1 of Japanese Patent Application No. 44888/1991 by the present application as well as the description of that figure can be referred to regarding the processing device indicated in Fig. 7.

The following provides an explanation of the operation of the processing device indicated in Fig. 7 and the processing method of the present invention referring to that figure. First, when light-sensitive lithographic printing plates are inserted from the left end of the device as shown in the figure, control section 23 distinguishes between the light-sensitive layer and the non-light-sensitive layer based on the signal detected with optical sensors 22a and 22b. Based on that signal, quantitative pumps 19a and 19b are activated so that developing solution is sent to the surface for which a light-sensitive layer was detected at a prescribed timing and for a duration corresponding to the length of the inserted light-sensitive lithographic printing plates in the direction of transport.

With respect to the surface for which a light-sensitive layer was detected, developing solution is supplied to the surface of the light-sensitive layer by developing solution being injected to gap portion 80 from developing solution ports 81 and/or 82 following activation of quantitative pumps 19a and/or 19b corresponding to said surface. The supplied developing solution is transported to the right in the drawing while being retained in the gap between upper guide plate 78 and/or lower guide plate 79 and the light-sensitive lithographic printing plate. The plate surfaces of light-sensitive lithographic printing plates that appear from gap portion 80 are brushed with brush rollers 77a and 77b and squeezed by squeeze roller 6 to complete development. The light-sensitive lithographic printing plates are then transported to washing portion 72 followed by rinse/gum portion 73 where those respective processes are performed.

Those light-sensitive lithographic printing plates that can be processed according to the present invention include those plates provided with a layer composed of an optical crosslinking type light-sensitive resin composition, a photopolymerization type light-sensitive resin composition, a light-sensitive resin composition containing a diazo compound and a light-sensitive resin composition containing an o-quinonediazido compound, on the surface of a carrier having a hydrophilic surface. Line 12 of the upper left column to line 20 of the lower right column of page 6 of Japanese Unexamined Patent Publication No. 200154/1988 contains a detailed description of the above-mentioned light-sensitive lithographic printing plates.

The following provides a detailed explanation of the processing method of the present invention through its examples.

### Example 1

Various reflection sensors (having a detected light wavelength of 600 nm, ϑ₂=0°) were attached to function as sensors 22a and 22b in the automatic developing machine indicated in Fig. 1. Following measurement of the reflectance of the upper and lower surfaces of the PS plates to be processed, the surface was determined to be provided with a light-sensitive layer if the measured value was less than 0.35, and determined to not be provided with a light-sensitive layer if the measured value was 0.35 or greater. Control portion 23 was provided so that developing solution is supplied only to those surfaces provided with a light-sensitive layer.

SDP-12 (produced by Konica Corporation, positive-type PS plate developing solution) was diluted by a factor of 6 with water and charged into developing solution tank 18. Said developing solution was supplied to the upper and lower surfaces of the PS plates being processed by means of upper surface developing solution supply member 10 and lower surface developing solution supply member 13. The amount of developing solution supplied was made to be such that 200 ml of developing solution were supplied per 1 m² of the surface of the PS plates being processed (200 ml/m² per single surface in the case of dual-sided plates). In addition, the temperature of the developing solution was regulated to 27°C by heater 21, and the transport speed of the PS plates was regulated so that the developing time was 20 seconds.

15 liters of water were charged into washing water tank 30, and 15 liters of a solution, in which SRW-1 (produced by Konica Corporation, rinse solution) was diluted with water by a factor of 8, were charged into rinse/gum solution tank 34.

When a large number of ST-0117 plates (produced by Konica Corporation, positive-type PS plates, light-sensitive layer provided on one side only) measuring 1003 mm x 800 mm and exposed for 60 seconds at a distance of 1 meter using a 1 kW metal halide lamp, were processed with the light-sensitive layers of the plates facing both up and down under the conditions described above, the plates were able to be processed stably with developing solution only being supplied to the surfaces provided with a light-sensitive layer.

### Example 2

With the exception of attaching the color sensor indicated in Fig. 3 for sensors 22a and 22b in the automatic developing machine indicated in Fig. 1, and providing control portion 23 so as to supply developing solution only to the surface provided with a light-sensitive layer by determining whether or not a surface is provided with a light-sensitive layer (green to blue-green color) according to the detection of the colors of the upper and lower surfaces of the PS plates being processed, an experiment was conducted in the same manner as Example 1. As a result, the plates were able to be processed stably with developing solution always only being supplied to the surfaces provided with a light-sensitive layer in the same manner as Example 1.

### Comparative Example 1

When an experiment was conducted in the same manner as Example 2 with the exception of stopping the operation of sensors 22a and 22b in the automatic developing machine indicated in Fig. 1, an amount of developing solution twice that of the amount used in Example 2 was consumed due to developing solution always being supplied to both surfaces of the PS plates being processed.

### Example 3

Reflection sensors similar to those used in Example 1 were attached as sensors 22a and 22b in the automatic developing machine indicated in Fig. 7. In addition, control portion 23 was provided so as to operate in a manner similar to Example 1.

After diluting SD-32 (produced by Konica Corporation, common negative-positive type developing solution), which was used for the developing solution, with water by a factor of 6 in developing solution mixing tank 86, said diluted developing solution was sent to upper and lower guide plates 78 and 79 by quantitative pumps 19a and 19b to supply developing solution to the surfaces of the PS plates being processed. The amount of developing solution supplied was made to be such that 200 ml of developing solution were supplied per 1 m² of the surface of the PS plates being processed (200 ml/m² per single surface in the case of dual-sided plates). The temperatures of heaters 90a and 90b were regulated so that the temperature of the developing solution was 27°C. In addition, the temperature of the pair of preheating rollers 74 was regulated to 40°C.

The transport speed of the PS plates was regulated so that the developing time was 20 seconds. 15 liters of water were charged into washing water tank 92, and 15 liters of a solution, in which SGW-2 (produced by Konica Corporation, gum solution) was diluted with water by a factor of 2, were charged into rinse/gum solution tank 93.
When a large number of ST-0117 plates exposed for 60 seconds at a distance of 1 meter using a 1 kW metal halide lamp, and a large number of SWN-X plates (Konica, negative-type PS plates, light-sensitive layer provided on one side only) measuring 1003 mm x 800 mm, were processed with the light-sensitive layers of the plates facing both up and down under the conditions described above, the plates were able to be processed stably with developing solution always only being supplied to the surfaces provided with a light-sensitive layer.

### Comparative Example 2

When an experiment was conducted in the same manner as Example 3 with the exception of stopping the operation of sensors 22a and 22b in the automatic developing machine indicated in Fig. 7, an amount of developing solution twice that of the amount used in Example 3 was consumed due to developing solution always being supplied to both surfaces of the PS plates being processed.

### Example 4

When an experiment was conducted in the same manner as Example 3 with the exception of only processing SWN-X plates measuring 1003 mm x 800 mm, the plates were able to be processed stably with developing solution always only being supplied to the surfaces provided with a light-sensitive layer in the same manner as Example 3.

### Example 5

When an experiment was conducted in the same manner as Example 3 with the exception of only processing ST-0117 plates measuring 1003 mm x 800 mm, the plates were able to be processed stably with developing solution always only being supplied to the surfaces provided with a light-sensitive layer in the same manner as Example 3.

### Example 6

An experiment was conducted in the same manner as Example 3 with the exception of attaching the color sensor indicated in Fig. 3 for sensors 22a and 22b in the automatic developing machine indicated in Fig. 7, and providing control portion 23 so as to supply developing solution only to the surface provided with a light-sensitive layer by determining whether or not a surface is provided with a light-sensitive layer (green to blue-green color) according to the detection of the colors of the upper and lower surfaces of the PS plates being processed. As a result, the plates were able to be processed stably with developing solution always only being supplied to the surfaces provided with a light-sensitive layer in the same manner as Example 3.

### Example 7

When an experiment was conducted in the same manner as Example 6 with the exception of processing only SWN-X plates measuring 1003 mm x 800 mm, the plates were able to be processed stably with developing solution always only being supplied to the surfaces provided with a light-sensitive layer in the same manner as Example 6.

### Example 8

When an experiment was conducted in the same manner as Example 6 with the exception of processing only ST-0117 plates measuring 1003 mm x 800 mm, the plates were able to be processed stably with developing solution always only being supplied to the surfaces provided with a light-sensitive layer in the same manner as Example 6.

According to the present invention, even a mixture of dual-sided and single-sided plates can be processed both economically and stably with a single in processing method and processing device wherein essentially unused developing solution is supplied and then disposed of after use.

## Claims

1. A processing method for light-sensitive lithographic printing plates comprising a support and provided on one or both sides thereof, a light-sensitive layer, comprising imagewise exposing the light-sensitive layer of the light-sensitive lithographic printing plate and developing the exposed light-sensitive layer, wherein the exposed light-sensitive layer is detected followed by supplying the developing solution only to the detected light-sensitive layer.

2. A processing device for developing an imagewise exposed light-sensitive layer of a light-sensitive lithographic printing plate by supplying substantially unused developing solution to the exposed light-sensitive layer, the light-sensitive lithographic printing plate comprising a support and provided on one or both sides thereof, a light-sensitive layer, comprising;
means for detecting the exposed light-sensitive layer, and
means for supplying the developing solution only to the detected light-sensitive layer.

3. The method of claim 1, wherein the light-sensitive lithographic printing plates are first detected with an optical sensor, and the presence of a light-sensitive layer is determined by a control portion based on that detected signal.

4. The method of claim 3, wherein after the presence of a light-sensitive layer has been determined by the control portion, a pump is activated so that developing solution is accordingly sent to the surface for which a light-sensitive layer has been detected at a prescribed timing and for a duration corresponding to the length in the transport direction of the light-sensitive lithographic printing plates that were inserted.

5. The method of claim 1, wherein a means for distinguishing surfaces provided with a light-sensitive layer and those that are not performs such distinction by detecting the difference in the reflectance between the light-sensitive layer and non-light-sensitive layer of light-sensitive lithographic printing plates.

6. The method of claim 1, wherein a means for distinguishing surfaces provided with a light-sensitive layer and those that are not performs such distinction by detecting a color difference between the light-sensitive layer and non-light-sensitive layer of light-sensitive lithographic printing plates.

7. The method of claim 5, wherein said means for distinction is a reflection sensor.

8. The method of claim 6, wherein said means for distinction is a color sensor.
